# EUROPÄISCHE PATENTSCHRIFT

(11) **EP 0 980 322 B1**
(45) Veröffentlichungstag und Bekanntmachung des Hinweises auf die Patenterteilung: **16.01.2002**
(21) Anmeldenummer: 98933433.9
(22) Anmeldetag: 04.05.1998
(51) Int. Cl.: B60R 21/00, H05K 5/00, H01R 4/24

(54) **SENSORSCHALTUNG FÜR KRAFTFAHRZEUGE**
SENSOR CIRCUIT FOR AUTOMOBILES
CIRCUIT DETECTEUR POUR VEHICULES AUTOMOBILES

(30) Priorität: 07.05.1997 DE 19719455
(43) Veröffentlichungstag der Anmeldung: 23.02.2000
(73) Patentinhaber: SIEMENS AKTIENGESELLSCHAFT, 80333 München (DE)
(72) Erfinder: BAHR, Andreas, D-93051 Regensburg (DE); PLANKL, Christian, D-93055 Burgweinting (DE); DIRMEYER, Josef, D-92439 Bodenwöhr (DE); BAUER, Hans-Peter, D-93049 Regensburg (DE); PROBST, Heinrich, D-93105 Tegernheim (DE)
(86) Internationale Anmeldenummer: DE9801218
(87) Internationale Veröffentlichungsnummer: WO9850255

(56) Entgegenhaltungen:
- EP-A- 0 557 917
- EP-A- 0 595 735
- DE-A- 4 409 971
- DE-C- 4 237 072

## Beschreibung

Die vorliegende Erfindung betrifft eine Sensorschaltung für Kraftfahrzeuge zur Sitzbelegungserkennung und/oder Kindersitzerkennung.

Aus der DE 42 37 072 C1 und DE 44 09 971 C2 sind Sensorschaltungen zur Sitzbelegungserkennung bzw. Kindersitzerkennung bekannt, bei denen die mattenförmig ausgebildeten Sensorfolien im Kraftfahrzeugsitz angebracht sind. Die von der Sensorfolie abgegebenen, den Sitzbelegungszustand repräsentierenden Signale werden einem dort nicht näher dargestellten Steuergerät zur Airbag-Steuerung zugeführt.

Allgemein ist die Auswerte- und Ansteuerelektronik zumindest teilweise, beispielsweise in Form einer Schnittstellenschaltung, ebenfalls in den Fahrzeugsitz integriert und zum Beispiel über einen Kabelbaum elektrisch mit dem an anderer Stelle im Fahrzeug angeordneten Steuergerät zur Airbagauslösung oder zur Steuerung anderer Funktionen, beispielsweise der Kopfstützen-Ausfahrposition, verbunden. Hierbei ist die Elektronik im Fahrzeugsitz als Schaltung auf einer herkömmlichen, starren Leiterplatte ausgebildet, die mit Kunststoff umspritzt ist und eingelötete Anschlußstifte für den Steckeranschluß und Sensoranschluß aufweist. Im elektrischen Strompfad sind somit zwischen der Sensorfolie und der Leiterplatte einerseits sowie zwischen der Leiterplatte und dem abgehenden Kabelbaum andererseits zahlreiche Übergangskontaktpunkte vorhanden, beispielsweise zwischen den Sensorfolien-Leiterbahnen und den mit ihnen verbundenen elektrischen Verbindern, den Verbindungsstellen zwischen diesen elektrischen Verbindern und den eingelöteten Anschlußstiften der Leiterplatte, im Übergangsbereich zwischen dem Anschlußstift und der zugehörigen Leiterplatten-Leitungsbahn, sowie an den Verbindungsstellen zwischen den Leiterplatten-Leiterbahnen und den einzelnen Adern des an die Leiterplatte angeschlossenen Steckers, sowie im Kontaktbereich zwischen den elektrischen Verbindungselementen des Steckers und den mit diesen kontaktierten Kontaktelementen des zum Beispiel mit dem Kabelbaum verbundenen Gegensteckverbinders. Durch diese Vielzahl von elektrischen Übergangsstellen ist die Gefahr einer fehlerhaften elektrischen Kontaktierung mit der Möglichkeit des Ausfalls der gesamten Sensorschaltung erhöht und auch der zur Herstellung und Überprüfung der elektrischen Kontaktierungen erforderliche Arbeits- und Zeitaufwand relativ hoch.

Der Erfindung liegt die Aufgabe zugrunde, eine Sensorschaltung zu schaffen, die die Möglichkeit einer verbesserten elektrischen Kontaktierung zwischen dem Schaltungsträger und den von diesen abgehenden Komponenten bietet.

Diese Aufgabe wird mit den im Anspruch 1 genannten Merkmalen gelöst. Vorteilhafte Ausgestaltungen der Erfindung sind in den Unteransprüchen angegeben.

Bei der Erfindung sind somit entweder die Sensorfolie und der Schaltungsträger einstückig ausgebildet oder überlappen sich im elektrischen Anbindungsbereich. Durch die Verbindung der Sensorfolien-Leiterbahn mit zugehörigen Leiterbahnen an der Schaltungsträger-Unterseite durch anisotropen, leitenden Kleber wird eine gute mechanische und zuverlässige elektrische Verbindung erreicht, insbesondere aufgrund der möglichen langgestreckten Kontaktierungszone zwischen den Leiterbahnen.

Eine Kontaktierung mit Leiterbahnen an der Sensorfolien-Oberseite erfolgt hierbei über einen Heißsiegel-Verbinder, der die Höhenstufe zwischen den Leiterbahnebenen überbrückt und eine gleichzeitige Herstellung aller notwendigen Kontaktierungen in einem einzigen Arbeitsvorgang ermöglicht, ein Vorteil, der auch bei dem Einsatz des anisotropen Klebers gegeben ist.

Bei der ersten Alternative lassen sich die zur Verbindung zwischen den auf dem Schaltungsträger vorhandenen Komponenten und der Sensorfolie über durchgehende elektrische Leiterbahnen auf der einstückigen Folie erzielen, so daß keine separaten Kontaktelemente erforderlich sind und der elektrische Durchgang dieser Leiterbahnen problemlos dauerhaft gewährleistet ist. Kontaktstifte, Lötstellen oder dergleichen, wie sie bislang zur Herstellung der Verbindung zwischen der Sensorfolie und den Leiterbahnen des Schaltungsträgers erforderlich waren, können somit ersatzlos entfallen.

Bei der zweiten Alternative der überlappenden Ausbildung des Schaltungsträgers und der Sensorfolie lassen sich die notwendigen elektrischen Verbindungen zwischen Schaltungsträger und Sensorfolie entweder durch direkte gegenseitige Anlage der zu kontaktierenden Leiterbahnen auf dem Schaltungsträger und der Sensorfolie erhalten, beispielsweise durch Heißsiegeln. Es können alternativ oder zusätzlich auch Verbinder, zum Beispiel Crimpverbinder eingesetzt werden, die aufgrund der überlappenden Ausführungen nur äußerst geringe räumliche Abstände zwischen den Leiterbahnen des Schaltungsträgers und der Sensorfolie zu überbrücken haben, so daß sich äußerst kurze Stromwege ergeben. Zudem kann die durch diese Verbinder ausgeübte mechanische Spannung zugleich auch dazu benutzt werden, die Sensorfolie und den Schaltungsträger im Verbindungsbereich mechanisch aneinander zu pressen, was gleichfalls die Kontaktsicherheit erhöht, da die Sensorfolie und der Schaltungsträger keine gegenseitige Ausweichbewegung ausüben können. Zugleich führt diese mechanische feste Verbindung auch zu erhöhter Stabilität und Reißfestigkeit der gesamten Anordnung, so daß ein unerwünschtes Entkoppeln dieser Komponenten mit hoher Zuverlässigkeit vermeidbar ist.

Bei der Erfindung können somit separate Anschlußstifte entfallen. Darüber hinaus läßt sich eine sehr flache Ausgestaltung, d.h. geringe Bauhöhe im elektrischen Kontaktbereich erreichen. Ebenso läßt sich die für den Kontaktierungsbereich belegte Fläche sehr klein halten, da nur sehr geringe Distanzen zu überbrücken sind und sich somit die einzelnen Anschlüsse sehr dicht anordnen lassen.

Die Sensorfolie kann hierbei unter dem Schaltungsträger hindurchgehen und an ihrem freien Ende die Kabelverbinder für den Anschluß an das Steuergerät tragen. Die Sensorfolie dient somit als Unterlage für den Schaltungsträger, so daß eine gute mechanische Verbindung zwischen diesen Komponenten herstellbar ist, und stellt zugleich auch alle Anschlußverbindungen zwischen dem Schaltungsträger und dem Sensorelement sowie dem Steuergerät bereit.

Der Schaltungsträger kann vorzugsweise als flexible Leiterplatte ausgelegt sein. Die Verbindung zwischen dem Schaltungsträger und der Sensorfolie kann in diesem Fall auch über Folien/Folien-Crimpverbinder hergestellt werden, die die Folien in zuverlässigen elektrischen und mechanischen Kontakt bringen.

Die flexible Leiterplatte kann hierbei einen in mindestens zwei Zungen unterteilten elektrischen Anschlußbereich aufweisen, wobei die Zungen aufgrund der Flexibilität der Leiterplatte umfaltbar sind. Durch diese Umfaltung der Zungen läßt sich eine Anpassung der Kontaktbelegung und Kontaktorientierung an unterschiedliche Sensorfolientypen mit unterschiedlicher Kontaktanordnung erreichen, ohne daß irgendwelche Adapter-Zwischenstücke erforderlich sind.

Der Schaltungsträger kann in alternativer Ausgestaltung auch ein Stanzgitter sein, an dem in vorteilhafter Ausgestaltung Kabel-Crimpverbinder und/oder Folien-Crimpverbinder einstükkig ausgebildet sein können. Am Stanzgitter können hierbei vorzugsweise auch Zugentlastungsstifte ausgebildet sein, die mit der Sensorfolie mechanisch verbunden sind und somit auf diese Komponenten einwirkende Zugkräfte aufnehmen können. Damit ist der elektrische Anbindungsbereich von solchen Zugspannungen entlastet, so daß die elektrische Kontaktsicherheit unbeeinträchtigt gegeben bleibt.

Die erfindungsgemäße Sensorschaltung ist insbesondere für den Einsatz bei einem Fahrersitz zur Sitzbelegungserkennung oder Kindersitzerkennung ausgelegt, wobei die Sensorsignale vorzugsweise zur Steuerung eines Airbags (Smart-Airbag) dienen, jedoch auch zu anderen Zwecken, zum Beispiel zum automatischen Ausfahren von Kopfstützen bei Erkennung einer Sitzbelegung, dienen können. Es ist auch möglich, die Sensorschaltung zur Erfassung anderer Parameter zu einzusetzen.

Das Sensorelement kann zum Beispiel ein Foliendrucksensor sein, der auch als FSR-Sensor (FSR = force sensing resistor) bekannt ist.

Die Erfindung schafft folglich die Möglichkeit einer integrierten Interface-Elektronik für eine Sitzbelegungserkennung oder eine Kindersitzerkennung mit einer Direktanbindung an eine Foliendrucksensor-Folie und Anschluß an ein elektronisches Steuergerät, d.h. stellt vorzugsweise einen Bestandteil einer solchen Insassenschutzsystems dar und wird wegen ihrer geringen Bauhöhe bevorzugt im Kraftfahrzeug-Sitz eingebaut.

Die Erfindung wird nachstehend anhand von Ausführungsbeispielen unter Bezugnahme auf die Zeichnungen näher beschrieben.
Es zeigen:
- Fig. 1: eine perspektivische Ansicht der wesentlichen Komponenten eines ersten Ausführungsbeispiels der erfindungsgemäßen Sensorschaltung,
- Fig. 2: eine von der Sensorfolie her gesehene seitliche Ansicht des in Fig. 1 dargestellten Ausführungsbeispiels,
- Fig. 3: eine von der linken Seite her gesehene Seitenansicht des Ausführungsbeispiels gemäß Fig. 1,
- Fig. 4a) bis 4d): einen bei dem Ausführungsbeispiel gemäß den Fig. 1 bis 3 eingesetzten Kabel-Crimpverbinder,
- Fig. 5: eine vergrößerte Darstellung des elektrischen Kontaktbereichs zwischen dem Schaltungsträger und dem kabelseitigen Ende der Sensorfolie in einem Zustand vor dem Heißsiegeln,
- Fig. 6: den in Fig. 5 dargestellten Abschnitt nach dem Heißsiegeln,
- Fig. 7a) bis 7c): eine beim Heißsiegeln einsetzbare Verbinder folie,
- Fig. 8: eine perspektivische Darstellung eines zweiten Ausführungsbeispiels der erfindungsgemäßen Sensorschaltung,
- Fig. 9a) und 9b): eine Draufsicht und eine Seitenansicht auf das Ausführungsbeispiel gemäß Fig. 8,
- Fig. 10a) bis 10c): einen beim zweiten Ausführungsbeispiel eingesetzten Folien/Folien-Crimpverbinder,
- Fig. 11: eine perspektivische Darstellung eines dritten Ausführungsbeispiels der erfindungsgemäßen Sensorschaltung,
- Fig. 12a) und 12b): eine Draufsicht bzw. eine Seitenansicht des dritten Ausführungsbeispiels,
- Fig. 13: ein bei dem dritten Ausführungsbeispiel eingesetztes Stanzgitter,
- Fig. 14a) bis 14c): eine vergrößerte Ansicht des Folienanbin dungsabschnitts beim dritten Ausführungsbeispiel,
- Fig. 15a) bis 15e): mehrere Ansichten eines beim dritten Ausführungsbeispiel eingesetzten Kabel-Crimpverbinders,
- Fig. 16a) bis 16c): mehrere Ansichten der beim dritten Ausfüh rungsbeispiel eingesetzten Folien-Crimpverbinder,
- Fig. 17: eine bei einem vierten Ausführungsbeispiel eingesetzte flexible Leiterplatte mit langgestreckten Folien-Anschlußzungen, und
- Fig. 18: eine Darstellung der in Fig. 17 gezeigten flexiblen Leiterplatte mit umgefalteten Anschlußzungen.

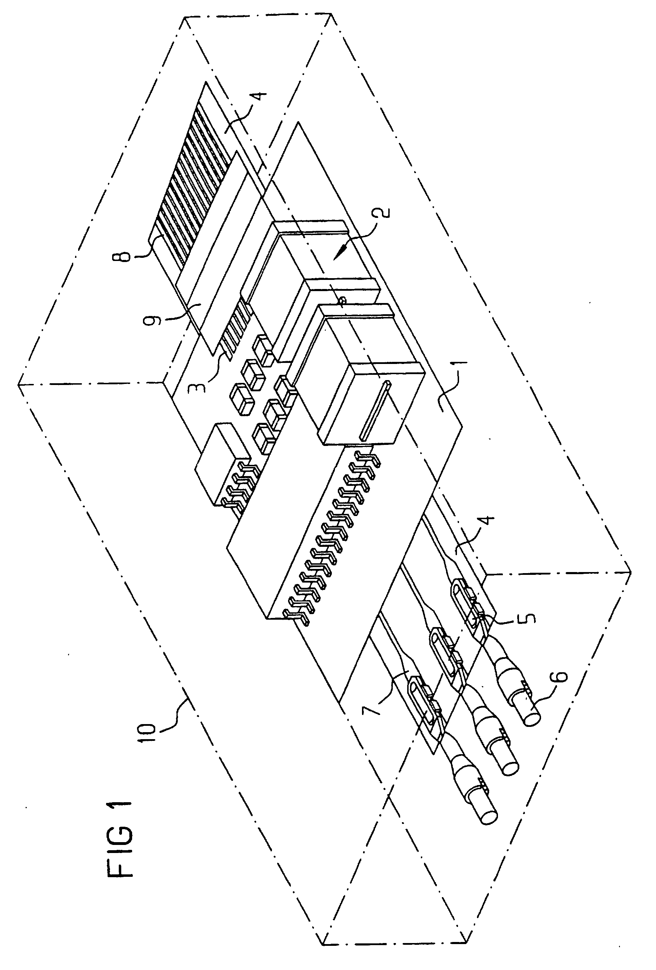

Das in den Fig. 1 bis 7 gezeigte erste Ausführungsbeispiel der Sensorschaltung weist einen Schaltungsträger 1 in Form einer flexiblen oder semi-flexiblen Leiterplatte auf, die als Folie aus Polyethylen oder Polyimid ausgebildet und mit schematisch dargestellten, elektronischen Bauelementen 2 bestückt ist. Die Bauelemente 2 können als oberlächenmontierbare SMD-Bauelemente ausgebildet sein, die sich automatisch bestücken lassen und mit dem Schaltungsträger 1, insbesondere bei Ausführung als Polyesterfolie, leitend verklebt sein können. Auf dem Schaltungsträger 1 sind Leiterbahnen im gewünschten Muster aufgebracht, die zum Beispiel aus Kupfer oder aus Silberleittinte bestehen können und lediglich teilweise schematisch im Sensorfolien-Anbindungsbereich mit dem Bezugszeichen 3 dargestellt sind. Der Schaltungsträger 1 mit den darauf aufgebrachten Komponenten bildet eine Interface-Elektronik für das Airbag-Steuergerät.

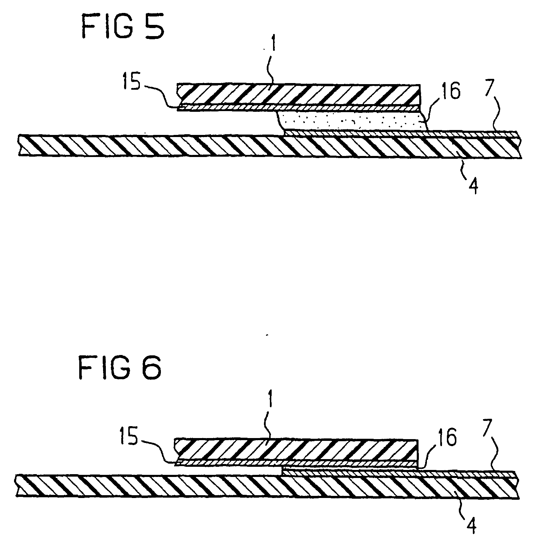

Der Schaltungsträger 1 ist auf eine Sensorfolie 4 aufgebracht, die unter dem Schaltungsträger 1 hindurch verläuft und am linksseitigen Ende über Folien-Kabel-Crimpverbinder 5 mit zu einem nicht dargestellten Steuergerät führenden Kabeln 6 verbunden ist. Auf der Oberseite der Sensorfolie im Kabel-Anbindungsbereich sind drei Leiterbahnen 7 aufgebracht, die mit entsprechenden Leiterbahnen an der Unterseite des Schaltungsträgers 1 kontaktiert sind (siehe Fig. 5 und 6), jedoch auch über entsprechende Durchgangslöcher oder über eine Heißsiegel-Verbinderfolie mit an der Oberseite des Schaltungsträgers 1 vorhandenen Leiterbahnen elektrisch verbunden sein können. Über die drei Leiterbahnen 7 werden die benötigten Betriebsspannungspotentiale zugeführt und die Signalabnahme (Sitz belegt/unbelegt) bewirkt.

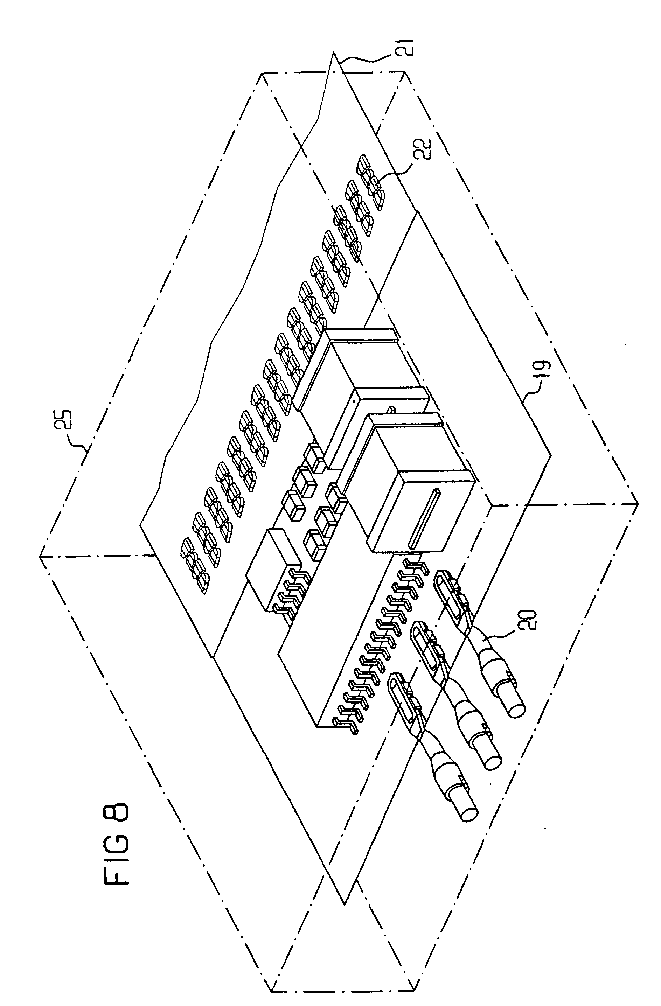

Die Sensorfolie 4 kann eine FSR-Folie aus Polyethylen sein, auf die die Leiterbahnen mit Silberleittinte aufgedruckt sind. Die Sensorfolie kann auch eine schützende Deckfolie enthalten. Zur Herstellung der elektrischen Verbindung zwischen den auf der Sensorfolie 4 im Sensor-Anbindungsbereich vorhandenen Leiterbahnen 8 kann eine Heißsiegel-Anbindung (in Heat-Seal-Technologie hergestellte Anbindung) vorgesehen sein, wozu bei diesem Ausführungsbeispiel eine Heißsiegel-Verbinderfolie 9 (siehe insbesondere Fig. 7a) bis 7c)) eingesetzt wird. Die Sensorfolie 4 setzt sich nach rechts gemäß Fig. 1 fort und verbreitert sich dort zur Sensormatte zur Sitzbelegungserfassung.

Die gesamte Sensorschaltung ist einschließlich der Anbindungsbereiche vollständig durch einen Schutzblock 10 umhüllt, der in Fig. 1 mit strichpunktierten Linien dargestellt ist und durch Umspritzen mit Overmould, zum Beispiel mit Makromelt-Heißkleber, nach Herstellen aller benötigten Verbindungen gebildet ist. Aufgrund dieses Schutzblocks 10 ist kein zusätzlicher Manipulationsschutz erforderlich. Weiterhin erfüllt die Sensorschaltung hierdurch auch höhere Schutzklassen-Anforderungen.

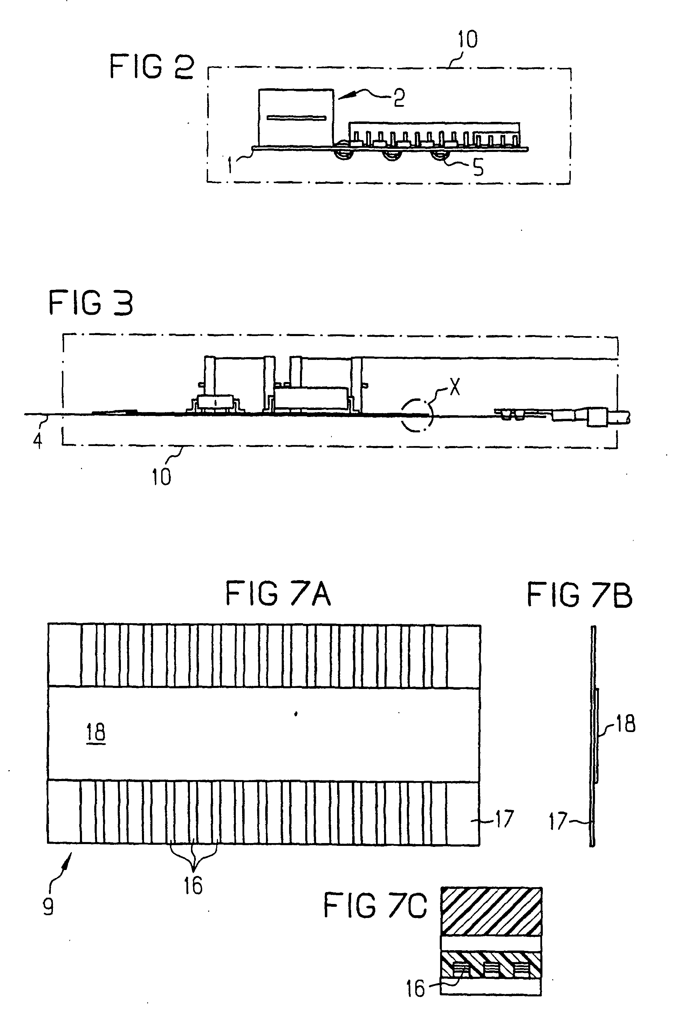

In den Fig. 2 und 3 sind zwei Seitenansichten, gesehen von der Seite der Sensorfolie bzw. von der linken Längsseite gemäß Fig. 1, dargestellt, aus denen ersichtlich ist, daß alle elektronischen Bauteile 2 auf der Oberseite des Schaltungsträgers 1 aufgebracht sind.

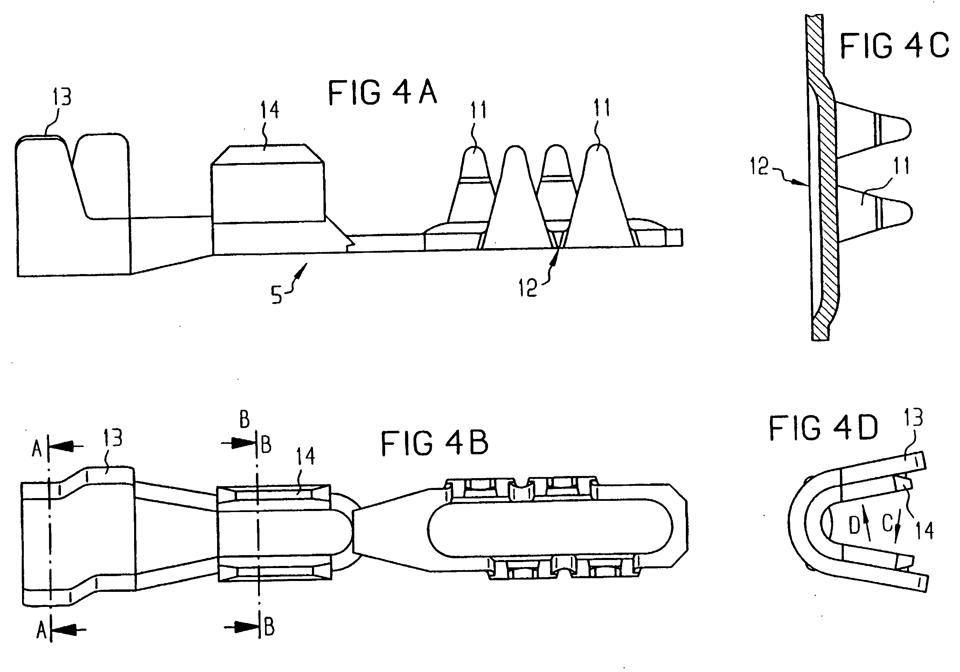

In den Fig. 4a) bis 4d) ist einer der Folien-Kabel-Crimpverbinder 5 in größeren Einzelheiten dargestellt. Der Folien-Kabel-Crimpverbinder 5 ist aus einem einstückigen Metallstück hergestellt und weist für die Anbindung an die Folie hochstehende Arme 11 auf, die zwischen sich einen durch Einbringen einer rückseitigen Einbuchtung ausgebildeten hochgewölbten Bereich 12 einschließen, so daß die mechanische und elektrische Verbindung mit der auf dem hochgewölbten Bereich aufliegenden Folie, die an ihrer Oberseite durch die umgefalzten Arme 11 gedrückt wird, stabil und belastbar ist. Dieser zur Folienkontaktierung dienende Bereich ist am rechten Ende (gemäß Fig. 4a)) des Folien-Kabel-Crimpverbinders ausgebildet, der an seinem linksseitigen Ende den Anschluß für das Kabel 6 aufweist. Hierbei dienen zwei hochstehende Arme 13 zur Klemmung der Kabelisolation, während die weiter innenliegenden hochstehenden Flächen 14 zur Klemmung des abisolierten Innenleiters des Kabels dienen. Bezüglich weiterer Einzelheiten des Folien-Kabel-Crimpverbinders 5 wird auf die detaillierte Darstellung gemäß den Fig. 4a) bis 4d) verwiesen, von denen Fig. 4a) eine Seitenansicht des Folien-Kabel-Crimpverbinders zeigt, während in Fig. 4b) eine Draufsicht dargestellt ist und Fig. 4c) einen partiellen Längsschnitt im Bereich der Auswölbung 12 zeigt. Fig. 4d) veranschaulicht die von links her (gemäß Fig. 4b)) gesehene Vorderansicht.

In den Fig. 5 und 6 ist der in Fig. 3 mit einem Kreis "X" hervorgehobene Bereich in vergrößerter Darstellung gezeigt, um hierdurch die elektrische Verbindung zwischen den Leiterbahnen 7 der Sensorfolie 4 und der Unterseite des Schaltungsträgers 1 zu verdeutlichen.

Wie aus den Fig. 5 und 6 ersichtlich ist, sind an der Unterseite des Schaltungsträgers 1 Leiterbahnen 15 an den den Position der Leiterbahnen 7 auf der Sensorfolie 4 entsprechenden Stellen angebracht. Die aufgedruckten Leiterbahnen 7 und 15 können zum Beispiel eine Dicke von 20 µm bei einer Dicke von Schaltungsträger 1 und Sensorfolie 4 von jeweils beispielsweise 50 µm aufweisen. Die Leiterbahnen 7 und 15 sind, wie aus den Fig. 5 und 6 ersichtlich ist, derart angeordnet, daß sie sich im elektrischen Kontaktierungsbereich überlappen. Im Kontaktierungsbereich ist ein anisotroper Kleber 16 eingebracht, der mit einem Kreis bezeichnete, elektrisch leitende Füllpartikel mit einem Durchmesser von z.B. 10 bis 12 µm enthält, die in einer als Klebstoff ausgebildeten Isolationsschicht enthalten sind. Fig. 5 zeigt den Zustand vor dem Heißsiegeln, während in Fig. 6 der Zustand nach der Heißsiegelung dargestellt ist, bei der der Schaltungsträger 1 und die Sensorfolie 4 im Kontaktierungsbereich mittels Druck und Wärme aneinander gedrückt werden. Da der nach dem Heißsiegeln erreichte Zustand zu einer Schichtdicke des Klebers 16 führt, die gleich oder kleiner als der Durchmesser der elektrisch leitenden Füllpartikel ist, stellen diese eine gute leitende Verbindung zwischen den zugehörigen Leiterbahnen 7 und 15 her, wobei die Leitung aber selektiv nur in der quer zur Kleberschichtebene verlaufenden Richtung erfolgt. Eine elektrische Leitung entlang der Schichtebene wird durch den die elektrisch leitenden Füllpartikel seitlich umgebenden isolierenden Klebstoff verhindert. Es läßt sich daher in dem in den Fig. 5 und 6 dargestellten Kontaktierungbereich eine vollflächige Verklebung quer zu der Zeichnungsebene erreichen, was zu guter, auch höheren Belastungen widerstehender mechanischer Verbindung zwischen der Sensorfolie 4 und dem Schaltungsträger 1 in diesem Bereich führt. Die elektrische Leitung erfolgt aber dennoch selektiv ausschließlich zwischen den jeweils zugeordneten Leiterbahnen 7 und 15 unter vollständiger Isolation zu den seitlich benachbarten Leiterbahnen.

In den Fig. 7a) bis 7c) sind eine Draufsicht, eine Seitenansicht bzw. eine Querschnittsansicht der in Fig. 1 gezeigten Heißsiegel-Verbinderfolie (Heat-Seal-Connector) 9 gezeigt, die die elektrische Kontaktierung zwischen den Sensorfolien-Leiterbahnen 8 und den auf der Oberseite des Schaltungsträgers 1 vorhandenen Leiterbahnen 3 herstellt. Die Verbinderfolie 9 enthält eine Mehrzahl von querverlaufenden, parallelen Leiterbahnen 16, die im gleichen Raster wie die Leiterbahnen 3 und 8 angeordnet und auf einer Grundfolie 17 aufgebracht sind. Die Leiterbahnen 16 sind in eine Klebstoffschicht eingebettet, die sie seitlich und rückseitig umgibt. Durch diese Klebschicht wird die Verbinderfolie 9 nach dem Aufbringen auf die Sensorfolie 4 und den Schaltungsträger 1 derart, daß die jeweiligen Leiterbahnen miteinander ausgerichtet sind und in elektrischen Kontakt gebracht sind, und nach dem Heißsiegel-Schritt mechanisch stabil mit der Sensorfolie 4 und dem Schaltungsträger 1 verbunden, so daß die elektrische Durchkontaktierung zwischen den zugehörigen Leiterbahnen 3 und 8 dauerhaft gewährleistet ist. Die Verbinderfolie 9 kann im mittleren Bereich in bekannter Weise eine zusätzliche, in Längsrichtung verlaufende Schicht 18 auf den Leiterbahnen 16 aufweisen, die aus isolierendem Material besteht und die zwischen den Oberflächen der Sensorfolie 4 und des Schaltungsträgers 1 bestehende Höhendifferenz beim Verbinden ausgleichen kann.

Bei diesem Ausführungsbeispiel läßt sich eine sehr hohe Integration der Schaltung erreichen. Weiterhin ist es auch möglich, für den Schaltungsträger 1 und die Sensorfolie 4 gleiches Basismaterial, zum Beispiel Polyester, zu verwenden, was zum Beispiel ein einfaches Recycling ermöglicht. Um Herstellungskosten zu optimieren, kann aufgrund der unterschiedlichen Flächenausdehnung von Sensorfolie 4 und Schaltungsträger 1 der Schaltungsträger 1 ein höherwertiges Basismaterial aufweisen als die Sensorfolie 4. Durch Verwendung eines flexiblen Schaltungsträgers 1 läßt sich im Vergleich mit starren Schaltungsträgern auch eine bessere Absorption von Schwingungen erzielen. Ferner sind im Vergleich zu herkömmlichen Lösungen weniger Schnittstellen vorhanden, so daß höhere Kontaktsicherheit erzielt wird und weniger mechanische Bauteile, zum Beispiel Crimpverbinder, benötigt wird. Durch Einsatz der Heat-Seal-Technologie läßt sich zudem ein unerwünschtes Einreißen der Folien verhindern und es sind auch weniger Arbeitsschritte erforderlich, da alle elektrischen Anschlüsse bei einem einzigen Arbeitsdurchgang hergestellt werden können. Dies ist auch hinsichtlich reduzierter Kosten vorteilhaft.

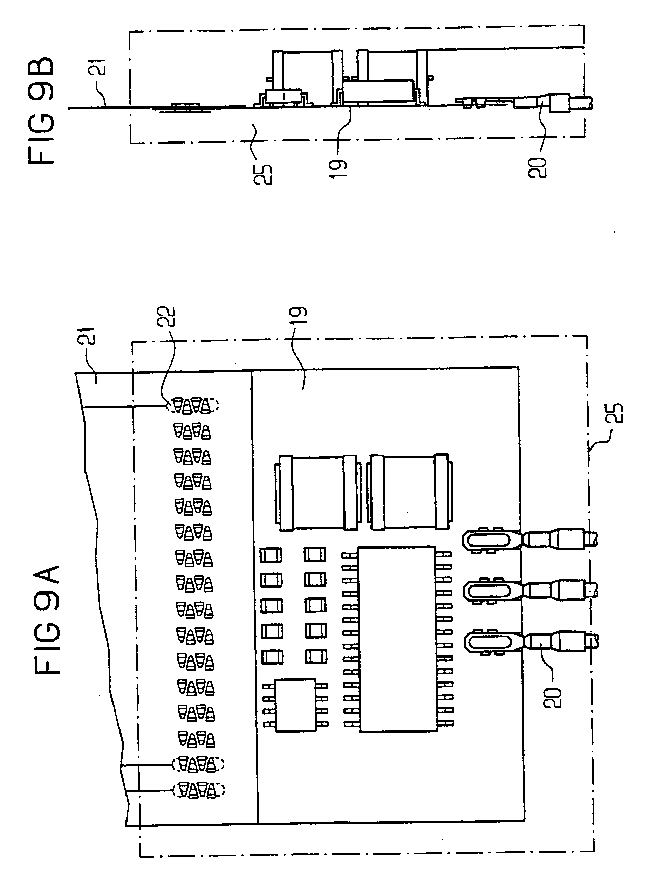

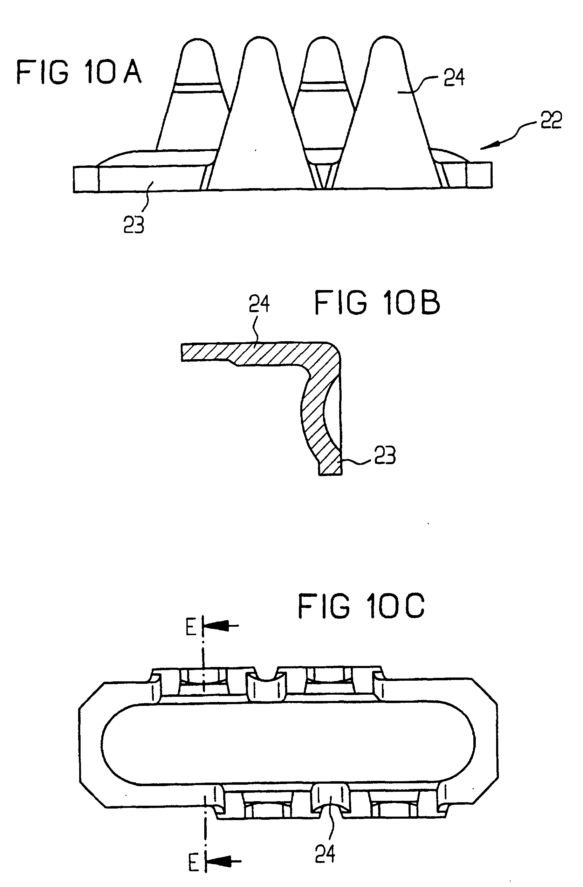

Unter Bezugnahme auf die Fig. 8 bis 10 wird nachfolgend das zweite Ausführungsbeispiel der erfindungsgemäßen Sensorschaltung beschrieben. Ein Schaltungsträger 19 ist als flexible Leiterplatte ausgebildet und kann dieselbe Gestaltung wie der Schaltungsträger 1 des vorstehend beschriebenen Ausführungsbeispiels aufweisen. Der Schaltungsträger 19 trägt in gleicher Weise wie bei dem ersten Ausführungsbeispiel die elektronischen Schaltungskomponenten und ist über Folien-Kabel-Crimpverbinder 20 mit den zum Steuergerät 1 führenden Kabeln verbunden. Die Folien-Kabel-Crimpverbinder 20 können identisch wie die Crimpverbinder 5 des ersten Ausführungsbeispiels ausgelegt sein, greifen bei diesem Ausführungsbeispiel aber direkt an dem Schaltungsträger 19 an und sind mit den zugehörigen, an dessen Ober- oder Unterseite ausgebildeten Leiterbahnen durch Crimpung elektrisch zuverlässig kontaktiert. Eine die Sitzfolie ausbildende Sensorfolie 21 liegt auf dem Schaltungsträger 19 überlappend in der aus den Fig. 8 und 9b) ersichtlichen Weise auf. Die elektrische Kontaktierung zwischen den in entsprechendem Raster auf der Sensorfolie 1 und dem Schaltungsträger 19 vorhandenen, zu kontaktierenden Leiterbahn erfolgt bei diesem Ausführungsbeispiel mittels Folien/Folien-Crimpverbindern 22, die parallel zueinander entsprechend dem Raster der nicht dargestellten Leiterbahnen angeordnet sind. Die Folien/Folien-Crimpverbinder 22 sind in den Fig. 10a) bis 10c) detaillierter dargestellt, wobei Fig. 10a) eine Seitenansicht, Fig. 10b) eine Schnittansicht entlang der Linie E-E in Fig. 10c), und Fig. 10c) eine Draufsicht auf einen Crimpverbinder 22 zeigen. Jeder Crimpverbinder 22 weist vier im unvercrimpten Zustand von einer in Längsrichtung in der Mitte hochgewölbten Bodenplatte 23 einstückig hochstehende Arme 24 auf. Zur Herstellung der Crimpverbindung werden die Crimpverbinder 22 von der Unterseite her durch die beiden überlappend aufeinandergelegten Endbereiche der Sensorfolie 21 und des Schaltungsträgers 19 an den entsprechenden Stellen hindurchgeführt, und die Arme 24 anschließend umgecrimpt. Hierdurch wird zuverlässige elektrische Kontaktierung und stabile mechanische Verbindung erzielt. Die Ausgestaltung der Folien/Folien-Crimpverbinder 22 entspricht im wesentlichen der in den Fig. 4a) und 4b) dargestellten rechten Hälfte des Folien-Kabel-Crimpverbinders 5. Bezüglich der Detail-Ausgestaltung wird auf die aus sich heraus verständlichen Fig. 10 und 4 verwiesen.

Da bei diesem Ausführungsbeispiel alle Crimpverbinder 22 parallel zueinander in einer Reihe angeordnet sind, ist das Ausmaß der notwendigen Überlappung zwischen Sensorfolie 21 und Schaltungsträger 19 reduziert und es läßt sich dennoch eine große Anzahl von elektrischen Verbindungen ohne Gefahr einer gegenseitigen unerwünschten Kontaktierung herstellen.

Wie bei dem ersten Ausführungsbeispiel ist auch bei diesem Ausführungsbeispiel der Schaltungsträger 19 einschließlich der elektronischen Bauteile und der Crimpverbinder 20, 22 sowie eines Teils der Sensorfolie 21 in einem Block 25 eingebettet, der zum Beispiel durch Umspritzen mit Overmould, zum Beispiel durch Makromelt-Heißkleber, hergestellt ist.

Bei diesem Ausführungsbeispiel ergeben sich die gleichen Vorteile, wie sie vorstehend bezüglich des ersten Ausführungsbeispiels bereits angegeben sind.

Alternativ ist es auch möglich, den Schaltungsträger 19 (bzw. 1 beim ersten Ausführungsbeispiel) entfallen zu lassen und stattdessen die elektrischen/elektronischen Bauteile 2 direkt auf die Sensorfolie 21 (bzw. 4) in der bezüglich der Schaltungsträger 19 (bzw. 1) bekannten Weise aufzubringen. In diesem Fall bilden Schaltungsträger und Sensorfolie eine Einheit. Die Leiterbahnen können somit direkt auf der Sensorfolie zu den entsprechenden, auf ihr aufgebrachten elektrischen/elektronischen Bauteile geführt sein, so daß Folien/Folien-Crimpverbindungen (oder Heat-Seal-Verbindungen) entfallen können. Hierdurch ist der Herstellungsaufwand noch weiter verringert und die elektrische Kontaktsicherheit (aufgrund des zusätzlichen Entfalls von elektrischen Übergangsstellen) noch weiter erhöht.

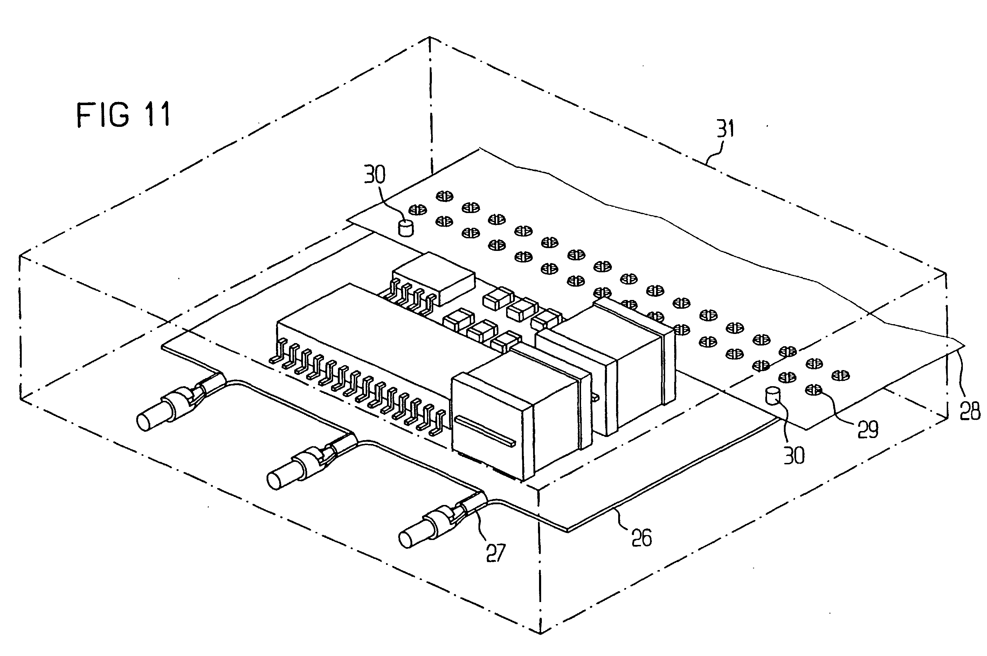

Unter Bezugnahme auf die Fig. 11 bis 16 wird nachfolgend ein drittes Ausführungsbeispiel der erfindungsgemäßen Sensorschaltung beschrieben. Bei diesem Ausführungsbeispiel ist ein die schematisch dargestellten elektrischen/elektronischen Komponenten (Interface- Elektronik) der Sensorschaltung tragender Schaltungsträger 26 durch ein Stanzgitter (Leadframe) gebildet. Bei diesem Ausführungsbeispiel sind die zum Anschluß an den Kabelbaum und das Steuergerät vorgesehenen drei Kabel-Crimpverbinder 27 direkt am Schaltungsträger 26 einstückig ausgebildet. Somit ist zwischen den Crimpverbindern 27 und dem Schaltungsträger 26 keine elektrische Übergangsgrenzfläche vorhanden, wie es bei Einsatz von separat ausgebildeten und dann mit der Leiterplatte 26 kontaktierten Crimpverbindern 27 der Fall wäre. Damit ist der elektrische Übergangswiderstand minimal und die Gefahr von Kontaktierungsfehlern in diesem Übergangsbereich ausgeschaltet. Zur Vermeidung elektrischer Kurzschlüsse durch das metallische Grundmaterial des Stanzgitters des Schaltungsträgers 26 kann dieses mit einer isolierenden Deckschicht überzogen sein, auf der die Leiterbahnen mit dem erforderlichen Verlauf bis auf die Oberfläche der Kabel-Crimpverbinder aufgebracht sind.

An dem Schaltungsträger 26 sind ferner zur elektrischen und mechanischen Kontaktierung mit einer Sensorfolie 28 Folien-Crimpverbinder 29 einstückig ausgebildet, so daß sich auch hier keinerlei elektrischer Übergangswiderstand vom Schaltungsträger zu den Folien-Crimpverbindern 29 ergibt und aufgrund der Einstückigkeit die elektrische und mechanische Verbindung zwischen diesen Komponeten dauerhaft gewährleistet bleibt. Ferner ist bei der Herstellung der elektrischen Verbindung auch kein separater Montageschritt zur Anbringung der Foliencrimps 29 oder der Kabel-Crimpverbinder 27 an dem Schaltungsträger 26 erforderlich, was den Arbeitsaufwand und Zeitaufwand deutlich verringert.

In dem Folien-Anbindungsbereich überlappen sich der Schaltungsträger 26 und die Sensorfolie 28 mit ihren Randbereichen, wobei die Sensorfolie 28 direkt auf dem Schaltungsträger 26 aufliegt und die von dem Schaltungsträger 26 ausgehenden Folien-Crimpverbinder 29 durch die Sensorfolie 28 an entsprechenden Positionen hindurchgeführt und oberseitig der Sensorfolie vercrimpt sind.

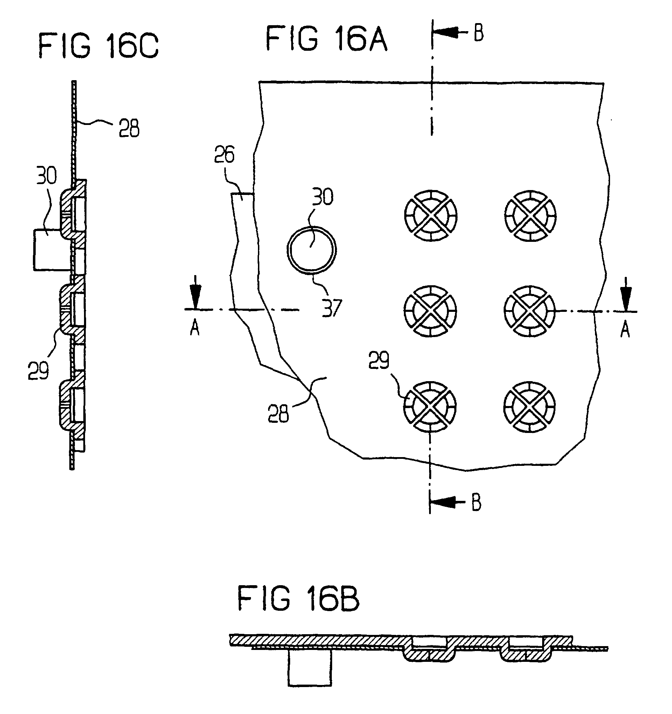

Zur Erzielung einer Zugentlastung sind an dem Schaltungsträger 26 ein oder mehrere, vorzugsweise zwei, hochstehende Zugentlastungsstifte 30 angeordnet, die mit dem Schaltungsträger fest verbunden sind. Die Zugentlastungsstifte 30 sind in dem Bereich zwischen den Folien-Crimpverbindern 29 und den elektronischen Komponenten auf dem Schaltungsträger 26, vorzugsweise in den seitlichen Randbereichen des Schaltungsträgers 26, positioniert und treten durch entsprechende, gleichen Durchmesser wie die vorzugsweise runden Zugentlastungsstifte 30 aufweisende Öffnungen 37 (Fig. 16a)) nahe den Randbereichen der Sensorfolie 28 hindurch. Damit ergibt sich eine hochbelastbare mechanische Verbindung zwischen der Sensorfolie 28 und dem Schaltungsträger 26, so daß eventuell auftretende Zugkräfte aufgenommen werden können und diese folglich nicht zu einem unerwünschten Lösen oder Abreißen der Sensorfolie 28 führen.

Auch bei diesem Ausführungsbeispiel ist der Schaltungsträger 26 einschließlich der Crimpverbinder und des Randbereichs der Sensorfolie 28 vollständig durch einen Schutzblock 31 umgeben, der aus Vergußmasse, zum Beispiel aus Overmould wie etwa Makromelt-Heißkleber bestehen und gegossen oder gespritzt sein kann.

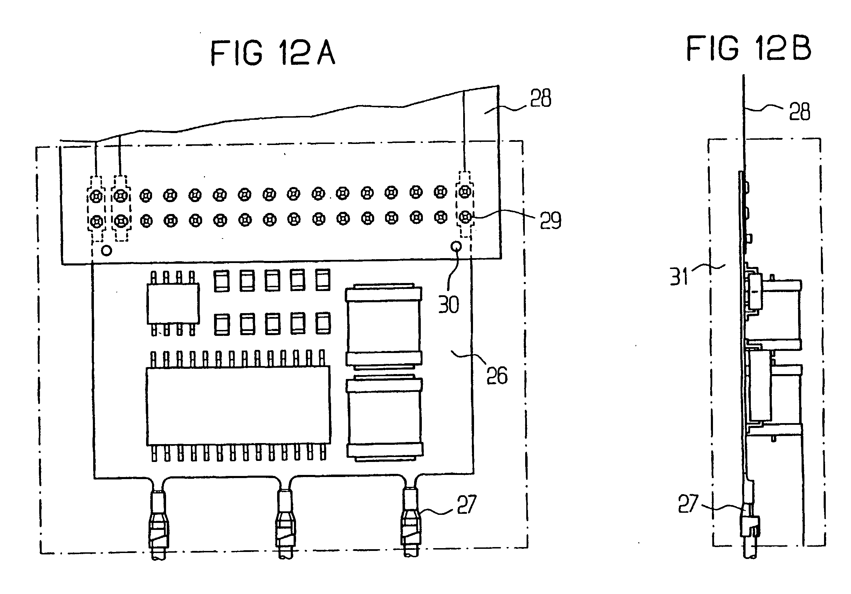

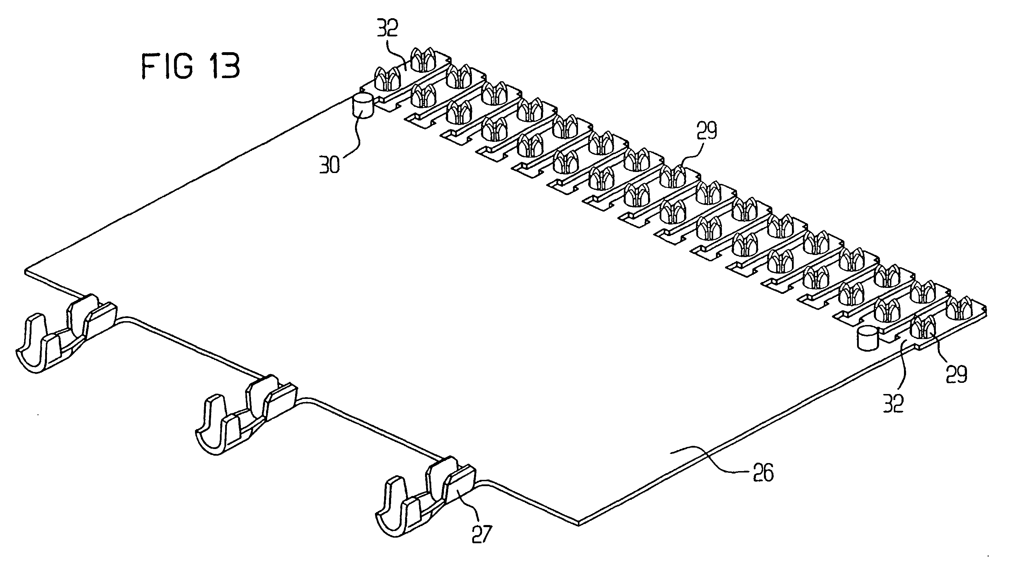

In den Fig. 12a) und 12b) sind eine Draufsicht und eine Seitenansicht des dritten Ausführungsbeispiels gezeigt, die aus sich selbst heraus verständlich sind. Fig. 13 zeigt den Schaltungsträger 26 in noch unbestückter Form mit noch unvercrimpten Kabel-Crimpverbindern 27 und Folien-Crimpverbindern 29. Aus Fig. 13 ist ersichtlich, daß der Schaltungsträger 26 im Sensorfolien-Anbindungsbereich eine Vielzahl von parallelen Armen 32 enthält, die durch Ausstanzen gebildet sind und von der Längsseite vorstehen. Die Arme 32 sind Bestandteil des Stanzgitters und verlaufen mit gegenseitigem Abstand, wobei sie in ihrem dem übrigen Teil des Schaltungsträgers 26 zugewandten Bereich verjüngt sind. Je Arm sind jeweils zwei hintereinander angeordnete Folien-Crimpverbinder 29 angeordnet, so daß jede Leiterbahn der Sensorfolie durch zwei in Leiterbahn-Längsrichtung angeordnete Folien-Crimpverbinder 29 umgriffen wird. Alle Folien-Crimpverbinder 29 sind somit in zwei zur Längsrichtung des Schaltungsträgers 26 parallelen Reihen ausgerichtet.

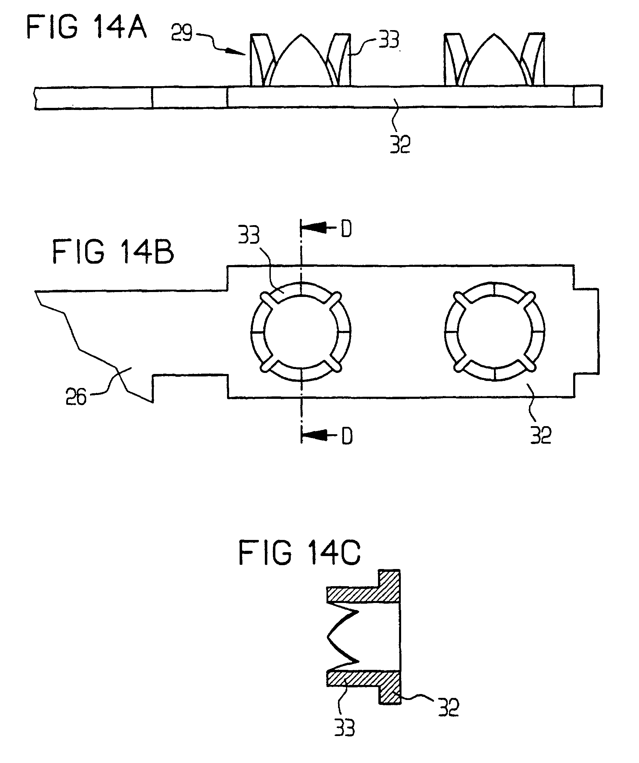

In den Fig. 14a) bis 14c) sind die Folien-Crimpverbinder 29 detailliert dargestellt, wobei Fig. 14a) eine von der rechten Seite her gesehene Seitenansicht eines Arms 32 mit hochstehenden Folien-Crimpverbindern 29 zeigt (hierbei ist der gemäß Fig. 13 links dargestellte Arm 32 gezeigt), während in Fig. 14b) eine Draufsicht auf den Arm 32 dargestellt ist und in Fig. 14c) ein Schnitt durch den Arm gemäß Fig. 14b) entlang der dort gezeigten Linie D-D veranschaulicht ist. Jeder Folien-Crimpverbinder 29 weist hierbei vier im unverkrümmten Zustand hochstehende Backen 33 auf, die durch kreuzweises Einschneiden der Arme 32 und Hochbiegen der durch die Einschnitte gebildeten vier Spitzen gebildet sind. Hierdurch ergibt sich eine einstückige Ausbildung der Folien-Crimpverbinder 29 ohne elektrischen Übergangswiderstand zu den Armen 32 und dem Schaltungsträger 26. Für diese Umformung kann zum Beispiel eine Biegepresse eingesetzt werden.

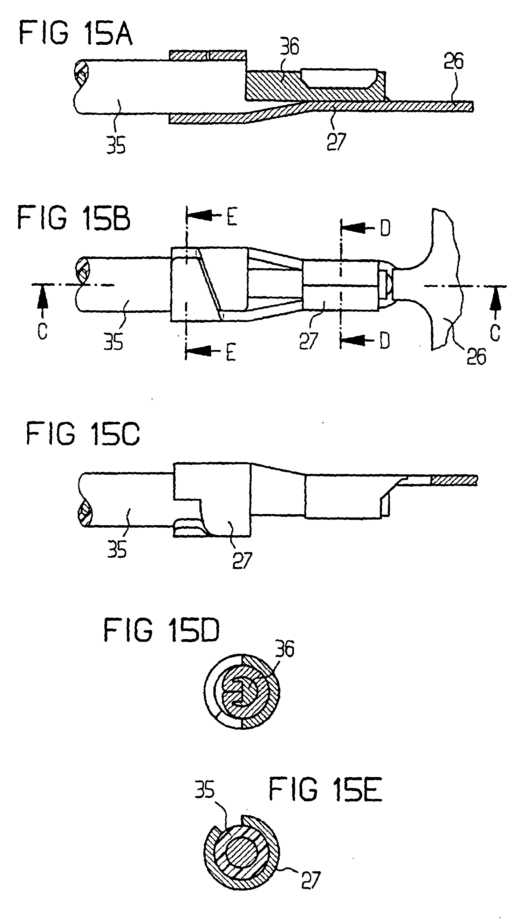

In den Fig. 15a) bis 15e) ist einer der Kabel-Crimpverbinder 27 in Draufsicht (Fig. 15b)), Seitenansicht (Fig. 15c)), Schnittansicht entlang der Schnittebene C-C in Fig. 15b) (Fig. 15a)), Schnittansicht entlang der Schnittebene D-D (Fig. 15d)) und Schnittansicht entlang der Schnittebene E-E (Fig. 15e)) gezeigt. Der Kabel-Crimpverbinder 27 geht unmittelbar, einstückig, in den Schaltungsträger 26 über, wobei die zum Umschließen des Kabelmantels und der Kabelseele dienenden Crimp-Backen durch entsprechend ausgestanzte und anschließend umgeformte Seitenbereiche des Schaltungsträger-Materials gebildet sind. Der Kabelmantel 35 wird hierbei durch die äußeren Crimp-Backen umschlossen, während der abisolierte Innenleiter 36 durch die weiter innen liegenden Crimp-Backen kontaktiert und geklemmt ist, wie dies aus den Fig. 15a) bis 15e) ersichtlich ist.

In den Fig. 16a) bis 16c) ist ein Ausschnitt der Sensorfolienanbindung dargestellt, wobei Fig. 16a) den linken oberen Bereich von Fig. 11 ausschnittsweise in Draufsicht zeigt, während in den Fig. 16b) und 16c) der Schnitt A-A bzw. B-B dargestellt ist. Wie aus Fig. 16a) ersichtlich ist, ist in der Sensorfolie eine runde Öffnung 37 vorgesehen, die formmäßig und lagemäßig an den durch sie hindurchtretenden Zugentlastungsstift 30 angepaßt ist.

Das dritte Ausführungsbeispiel bietet aufgrund der hohen Integration der einzelnen Crimpverbinder sehr gute mechanische und elektrische Zuverlässigkeit mit vernachlässigbaren elektrischen Kontaktverlusten. Weiterhin wird durch die Integration der Crimpverbinder die Anzahl der Fertigungsschritte und die Teileanzahl reduziert. Die elektronischen/elektrischen Bauelemente lassen sich automatisch bestücken, wobei auch ausschließlich SMD-Bauelemente verwendbar sind. Durch den Schutzblock 31 ergibt sich ferner ein eigenständiger Manipulationsschutz und auch die Erfüllung der Anforderungen hoher Schutzklassen.

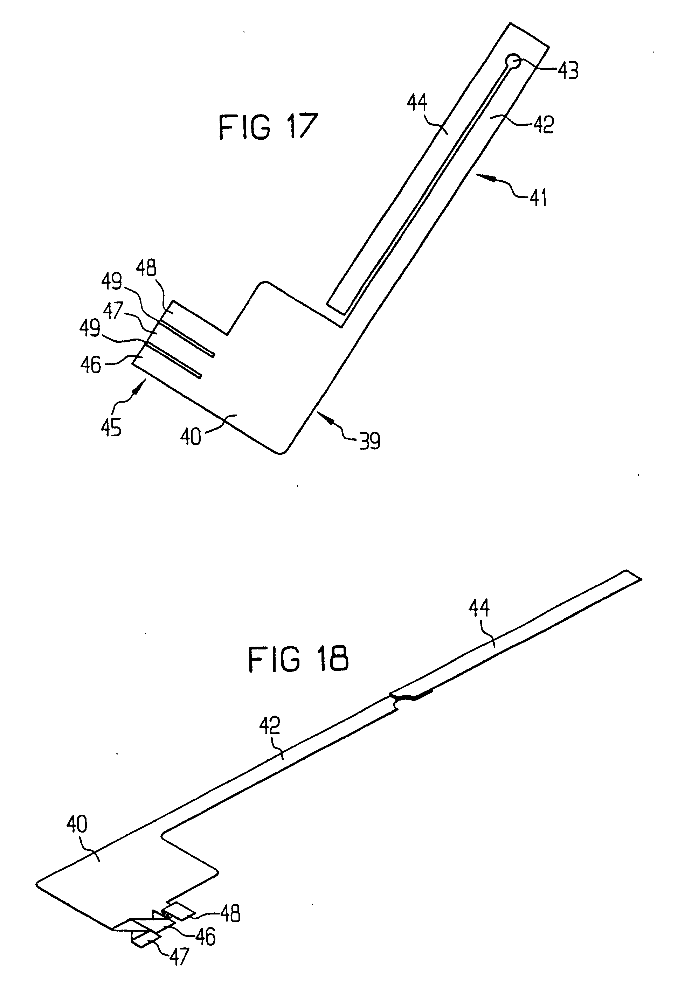

In den Fig. 17 und 18 ist ein viertes Ausführungsbeispiel gezeigt, wobei lediglich der. Schaltungsträger noch ohne aufgebrachte elektronische/elektrische Komponenten und ohne Anbindung an die Sensorfolie und die Zuleitungen zum Steuergerät dargestellt ist. Diese Anbindung kann z.B. in der vorstehend erläuterten Weise erfolgen.

Bei dem in den Fig. 17 und 18 gezeigten Schaltungsträger 39 ist ein Schaltungsträgerabschnitt 40 zur Aufnahme der Elektronikschaltungskomponenten und ein integral mit ihm ausgebildeter Kabelschwanz 41 vorhanden. Der Kabelschwanz 41 besteht aus zwei U-förmig angeordneten Schenkeln 42, 44, die über einen Quersteg einstückig miteinander verbunden sind, der auf der dem Schaltungsträgerabschnitt 40 abgewandten Schenkelseite vorgesehen ist und die auf oder in dem Kabelschwanz 41 vorhandenen elektrischen Verbindungsleitungen unterbrechungsfrei vom Schaltungsträgerabschnitt 40 zu dem freien Ende des Schenkels 44 durchverbindet. Die Schenkel 42, 44 sind in ihrem gegenseitigen Verbindungsbereich mit einer kreisförmigen Aussparung 43 versehen, die beim Stanzen der flexiblen Leiterplatte gebildet wird und das Einreißen des Kabelschwanzes 41 bei einer Verformung, zum Beispiel einer Umfaltung des Schenkels 44, verhindert.

Zum Anschluß an die nicht dargestellte Sensorfolie ist der Schaltungsträgerabschnitt 40 mit einem Anbindungsbereich 45 versehen, in dem die elektrischen Kontakte zur Kontaktierung mit der Sensorfolie angeordnet sind. Der Anbindungsbereich 45 ist in mindestens zwei, vorzugsweise drei Zungen 46, 47, 48 unterteilt, die durch Einschnitte 49 voneinander getrennt sind und somit unabhängig voneinander gebogen/gefaltet werden können. Die Einschnitte 49 sind ausreichend tief eingeschnitten und reichen zum Beispiel bis zu der Verlängerung derjenigen Seitenkante des Schaltungsträgerabschnitts 40, von der die Zungen 46 bis 48 ausgehen. Die an den Zungen 46 bis 48 ausgebildeten Kontakte sind über durchgehende Leiterbahnen mit den entsprechenden Montagepunkten der auf den Schaltungsträgerabschnitt 40 aufzubringenden elektrischen Bauelemente unterbrechungsfrei verbunden.

Fig. 18 zeigt den in Fig. 17 dargestellten Schaltungsträger 39 nach doppelter Umklappung des Schenkels 44, zuerst um die Querachse und dann um die Längsachse, derart, daß der axiale Verlauf des Schenkels 44 mit demjenigen des Schenkels 42 fluchtet. Hierdurch wird ein sich ausschließlich in Axialrichtung erstreckender, langgestreckter Kabelschwanz geschaffen, der sich geradlinig fortpflanzt und an seinem freien Ende mit einem Stecker zum Anschluß an das zugehörige Steuergerät des Kraftfahrzeugs versehen wird.

Aus Fig. 18 ist weiterhin ersichtlich, daß die Zungen 46, 47, 48 derart umgefaltet sind, daß die Position der Anschlußpins der Zungen 46 und 47 jeweils vertauscht sind. Die Faltung der Zungen ist jedoch derart durchgeführt, daß die Reihenfolge der Aufeinanderfolge der einzelnen Anschlußkontakte (Pins) in den einzelnen Zungen 46 bzw. 47 unverändert ist, das heißt die Zungen 46 und 47 sind nicht gewendet. Dies wird dadurch erreicht, daß gemäß diesem Ausführungsbeispiel die Zunge 46 zunächst um eine im Winkel von 45° zur Längsachse verlaufende Faltachse nach oben umgeklappt wird und dieser umgeklappte Teil dann erneut um eine parallel zu der ersten Faltachse liegende Achse nach außen gefaltet wird. Die Faltung der Zunge 47 erfolgt in ähnlicher Weise nach unten. Die Zunge 48 ist lediglich zweimal quer zu ihrer Längsachse gefaltet, so daß die Anschlußpins in der Zunge 48 ihre räumliche Lage beibehalten und lediglich der Abstand zum Schaltungsträgerabschnitt 40 in gleicher Weise verkürzt ist wie derjenige der Zungen 46 und 47. Die Anschluß-Stirnflächen der Zungen 46, 47 und 48 liegen daher auf gleicher Höhe, das heißt fluchten miteinander.

Durch diese Falttechnik ist es somit möglich, die räumliche Abfolge der Kontakte der Zungen 46, 47 und 48 in gewünschter Weise zu verändern und an unterschiedliche Kontaktbelegung von unterschiedlichen Sensorfolien, zum Beispiel von unterschiedlichen Herstellern, anzupassen. Es läßt sich somit eine einfache Anschlußvertauschung erreichen.

Je Zunge kann hierbei ein oder mehrere Leitungsanschlüsse vorgesehen sein. Eine Kreuzung der Anschlußleitungen, die je nach Anordnung der Elektronik relativ zur Sensorfolie bzw. in Abhängigkeit von der Anschlußbelegung der Sensorfolie erforderlich sein kann, läßt sich somit durch einfache Faltung, ohne sonstige elektrische Maßnahmen oder die Notwendigkeit eines Adapters, erreichen.

## Patentansprüche

1. Sensorschaltung für Kraftfahrzeuge zur Sitzbelegungserkennung und/oder Kindersitzerkennung mit einer Sensorfolie (4; 21; 28) zur Anordnung in einem Kraftfahrzeugsitz und einem mit der Sensorfolie elektrisch verbundenen Schaltungsträger (1; 19; 26; 39), der eine elektrische Schaltung zur Ansteuerung der Sensorfolie und/oder zur Umwandlung und/oder Auswertung der von der Sensorfolie zugeführten Signale trägt, **dadurch gekennzeichnet, daß** die Sensorfolie (4) und der Schaltungsträger (1) einander mindestens teilweise überlappen, daß auf der Sensorfolie (4) vorhandene Leiterbahnen (7) durch einen elektrisch anisotrop leitenden Kleber (16) mit zugehörigen Leiterbahnen (15) an der Unterseite des Schaltungsträgers (1) verbunden sind, und daß ein Heißsiegel-Verbinder (9) zur Verbindung von Leiterbahnen der Sensorfolie (4) mit Leiterbahnen (3) an der Oberseite des Schaltungsträgers (1) vorhanden ist.

2. Sensorschaltung nach Anspruch 1, **dadurch gekennzeichnet, daß** die Sensorfolie (4) unterhalb des Schaltungsträgers (1) verläuft und an ihrem freien Ende mit Kabelverbindern (5) zur Verbindung mit einem Steuergerät verbunden ist.

3. Sensorschaltung nach Anspruch 1 oder 2, **dadurch gekennzeichnet**, **daß** der Schaltungsträger (1; 19; 39) eine flexible Leiterplatte ist.

4. Sensorschaltung nach Anspruch 3, **gekennzeichnet durch** Folien/Folien-Crimpverbinder (22), die **durch** die Sensorfolie (21) und den Schaltungsträger (19) hindurchgeführt sind und diese zusammenspannen.

5. Sensorschaltung nach Anspruch 3 oder 4, **dadurch ge** **kennzeichnet**, **daß** die flexible Leiterplatte (39) einen in mindestens zwei Zungen (46, 47, 48) unterteilten Anschlußbereich (45) aufweist, wobei die Zungen vorzugsweise umfaltbar sind.

6. Sensorschaltung nach einem der Ansprüche 1 oder 2, **dadurch gekennzeichnet, daß** der Schaltungsträger (26) ein Stanzgitter ist.

7. Sensorschaltung nach Anspruch 6, **dadurch gekennzeichnet, daß** am Stanzgitter Kabel-Crimpverbinder (27) für den Kabelanschluß und/oder Folien-Crimpverbinder (29) zur Verbindung mit der Sensorfolie (28) einstückig ausgebildet sind.

8. Sensorschaltung nach Anspruch 6 oder 7, **dadurch gekennzeichnet, daß** am Stanzgitter (26) mindestens ein Zugentlastungsstift (30) ausgebildet ist, der in eine entsprechende Öffnung (37) der Sensorfolie (28) eingreift.

## Claims

1. Sensor circuit for motor vehicles for the purpose of seat occupancy detection and/or child seat detection with a sensor film (4; 21; 28) for installation in a motor vehicle seat and a circuit carrier (1; 19; 26; 39), connected electrically to the sensor film, which carries an electrical circuit for controlling the sensor film and/or for converting and/or evaluating the signals supplied by the sensor film, **characterised in that** the sensor film (4) and the circuit carrier (1) overlap one another at last partially, that conductor tracks (7) present on the sensor film (4) are connected by means of an electrically anisotropic adhesive (16) to associated conductor tracks (15) on the underside of the circuit carrier (1), and that a heat-seal connector (9) is provided to connect conductor tracks on the sensor film (4) to conductor tracks (3) on the upper side of the circuit carrier (1).

2. Sensor circuit in accordance with Claim 1, **characterised in that** the sensor film (4) passes beneath the circuit carrier (1) and is connected at its free end to cable connectors (5) for the connection to a control unit.

3. Sensor circuit in accordance with Claim 1 or 2, **characterised in that** the circuit carrier (1; 19; 39) is a flexible printed circuit board.

4. Sensor circuit in accordance with Claim 3, **characterised by** film/film crimp connectors (22) which are passed through the sensor film (21) and the circuit carrier (19) and clamp these together.

5. Sensor circuit in accordance with Claim 3 or 4, **characterised in that** the flexible printed circuit board (39) has a connection zone (45) divided into at least two lugs (46, 47, 48), where the lugs are preferably capable of bending.

6. Sensor circuit in accordance with Claim 1 or 2, **characterised in that** the circuit carrier (26) is a leadframe.

7. Sensor circuit in accordance with Claim 6, **characterised in that** cable crimp connectors (27) for the cable connection and/or foil crimp connectors (29) for connecting to the sensor film (28) are formed in a single piece on the leadframe.

8. Sensor circuit in accordance with Claim 6 or 7, **characterised in that** at least one strain relief post (30), which engages in a corresponding opening (37) in the sensor film (28), is formed on the leadframe (26).

## Revendications

1. Circuit de capteur, pour véhicule automobile, servant à la constatation d'occupation de siège et/ou la constatation de siège d'enfant, comprenant une feuille à capteur (4; 21; 28), destinée à être placée dans un siège de véhicule automobile, et un support de circuit (1 ; 19 ; 26 ; 39), relié électriquement à la feuille à capteur, qui porte un circuit électrique servant à la commande de la feuille à capteur et/ou à la transformation et/ou l'analyse des signaux envoyés par la feuille à capteur, **caractérisé en ce que** la feuille à capteur (4) et le support de circuit (1) se chevauchent au moins partiellement, **en ce que** des pistes conductrices (7) présentes sur la feuille à capteur (4) sont reliées, par l'intermédiaire d'une colle électriquement conductrice anisotrope (16), à des pistes conductrices (15) associées situées sur la face inférieure du support de circuit (1) et **en ce qu'**il est prévu un connecteur à thermosoudage (9) servant à la connexion de pistes conductrices de la feuille à capteur (4) avec des pistes conductrices (3) situées sur la face supérieure du support de circuit (1).

2. Circuit de capteur suivant la revendication 1, **caractérisé en ce que** la feuille à capteur (4) s'étend au-dessous du support de circuit (1) et est reliée, à son extrémité libre, à des connecteurs pour câble (5) servant à la connexion avec un dispositif de commande.

3. Circuit de capteur suivant la revendication 1 ou 2, **caractérisé en ce que** le support de circuit (1 ; 19 ; 39) est une plaquette de circuit imprimé souple.

4. Circuit de capteur suivant la revendication 3, **caractérisé par** des connecteurs de sertissage feuille/feuille (22) qui traversent la feuille à capteur (21) et le support de circuit (19) et soumettent ceux-ci à des contraintes.

5. Circuit de capteur suivant la revendication 3 ou 4, **caractérisé en ce que** la plaquette de circuit imprimé souple (39) comporte une zone de raccordement (45) divisée en au moins deux languettes (46, 47, 48), les languettes pouvant de préférence être pliées sur elles-mêmes.

6. Circuit de capteur suivant l'une des revendications 1 ou 2, **caractérisé en ce que** le support de circuit (26) est une grille découpée.

7. Circuit de capteur suivant la revendication 6, **caractérisé en ce que** des connecteurs à sertissage pour câble (27) destinés au raccordement de câbles et/ou des connecteurs à sertissage pour feuille (29) destinés à la connexion avec la feuille à capteur (28) sont réalisés, d'une seule pièce, sur la grille découpée.

8. Circuit de capteur suivant la revendication 6 ou 7, **caractérisé en ce qu'**au moins un ergot de décharge de traction (30) est réalisé sur la grille découpée (26), lequel ergot s'emboîte dans une ouverture (37) correspondante de la feuille à capteur (28).
